# FASCICULE DE BREVET EUROPEEN

(11) **EP 2 946 642 B1**
(45) Date de publication et mention de la délivrance du brevet: **30.08.2023**
(21) Numéro de dépôt: 14705713.7
(22) Date de dépôt: 21.01.2014
(51) Int. Cl.: H05K 3/34

(54) **ENSEMBLE SOUDE AVEC FREIN THERMIQUE**
SCHWEISSGRUPPE MIT THERMISCHER BREMSE
WELDED ASSEMBLY WITH THERMAL BRAKE

(30) Priorité: 21.01.2013 FR 1350526
(43) Date de publication de la demande: 25.11.2015
(73) Titulaire: Sagemcom Energy & Telecom SAS, 92500 Rueil-Malmaison (FR)
(72) Inventeur: ROLLAND, Patrick, F-92500 Rueil Malmaison (FR)
(74) Mandataire: Lavialle, Bruno François Stéphane
(86) Numéro de dépôt international: PCT/EP2014/051136
(87) Numéro de publication internationale: WO 2014/111594

(56) Documents cités:
- JP-A- S63 192 291
- JP-A- 2006 100 408
- JP-A- 2006 114 678
- JP-A- 2009 259 875
- JP-U- S 625 731

## Description

La présente invention concerne un ensemble soudé étant entendu que le terme soudé recouvre ici un ensemble obtenu indifféremment par tout procédé thermique de fixation tel que le soudage ou le brasage.

Il est connu des équipements électriques, tels que des compteurs comportant une plaque à circuit imprimé sur laquelle sont notamment fixés un relais de coupure et des conducteurs de puissance reliant les bornes du relais à des entrées du compteur. Le relais de coupure est généralement supporté en hauteur par rapport à plaque à circuit imprimé pour permettre la mise en place de composants sous le relais et contenir ainsi les dimensions de la plaque à circuit imprimé. Il en résulte que les conducteurs de puissance sont eux aussi fixés en hauteur sur la plaque à circuit imprimé.

Les contraintes techniques et les normes qui régissent la conception des compteurs font que les bornes du relais ne sont généralement pas disposées en regard des entrées du compteur de sorte que les conducteurs de puissance ont une forme non rectiligne permettant de relier les bornes du relais et les entrées du compteur.

Chaque conducteur de puissance est en cuivre et a la forme d'un barreau massif en saillie duquel s'étendent des pattes de fixation engagées dans des trous ménagés dans la carte à circuit imprimé.

Chaque patte de fixation comporte un tronçon intermédiaire épaulé formant entretoise pour maintenir le conducteur écarté de la plaque à circuit imprimé et un tronçon d'extrémité libre saillant axialement du tronçon intermédiaire pour s'étendre dans un trou et être soudé au circuit imprimé.

Compte tenu des tolérances de fabrication et de positionnement des compteurs, il est nécessaire de prévoir des trous ayant un diamètre très supérieur à la plus grande dimension transversale du tronçon d'extrémité libre pour autoriser un tolérancement très large des tronçons d'extrémité libres des pattes des conducteurs par rapport aux trous du circuit imprimé avant qu'ils ne soient fixés sur celle-ci. Pour permettre au tronçon intermédiaire de reposer sur le pourtour du trou, le tronçon intermédiaire doit être plus large que le trou.

Comme les conducteurs sont en cuivre, matériau thermiquement conducteur, et que les pattes de fixation doivent être chauffées pour permettre le soudage, un tronçon intermédiaire ayant une section transversale importante favorise l'évacuation de la chaleur vers le conducteur, empêchant le tronçon d'extrémité libre de s'échauffer suffisamment rapidement pour permettre le soudage qui est généralement réalisé « à la vague », c'est-à-dire avec une durée d'échauffement très brève. Il faut donc limiter le diamètre maximal des trous et donc les possibilités de réglage du positionnement des conducteurs ou souder les pattes de fixation manuellement lors d'une opération de reprise de soudage.

Il est connu du document JP-A-2009/259875 un ensemble soudé comportant une plaque dans laquelle ont été découpées des pattes de fixation dépourvues de tronçon d'extrémité libre et du document JP-U-S625731 un ensemble soudé selon le préambule de la revendication 1.

D'autres solutions sont également présentées dans les documents JP-A-2006/100408 et JP-A-S63192291. JP-A-2006/114678 décrit un ensemble soudé comprenant un composant électronique possédant des pattes de fixation ayant une zone à section transversale réduite afin de supprimer l'évacuation de la chaleur en direction du composant électronique lors du soudage.

Un but de l'invention est de fournir un moyen pour obvier à l'inconvénient précité.

A cet effet, on prévoit, selon l'invention, un ensemble soudé comprenant un élément en matériau thermiquement conducteur et un support, l'élément comportant une partie massive en saillie de laquelle s'étend au moins une patte de fixation comportant :
- un tronçon intermédiaire formant entretoise, le tronçon intermédiaire étant épaulé pour prendre appui sur une première face du support, de part et d'autre d'un trou ménagé dans le support, et ayant une épaisseur inférieure à une épaisseur du barreau ;
- un tronçon d'extrémité libre saillant axialement du tronçon intermédiaire pour s'étendre dans le trou et être soudé à une deuxième face du support opposée à la première face.

Le tronçon intermédiaire a une forme extérieure définissant localement une restriction de section.

La forme extérieure du tronçon intermédiaire est telle qu'elle présente localement une section transversale réduite par rapport à la section transversale dans le reste du tronçon intermédiaire. Ainsi, la restriction de section transversale procurée par la forme extérieure permet au tronçon intermédiaire d'avoir des dimensions transversales suffisamment grandes au niveau de son appui sur le support et une section transversale localement plus faible pour limiter le transfert de chaleur vers la partie massive.

D'autres caractéristiques et avantages de l'invention ressortiront à la lecture de la description qui suit d'un mode de réalisation particulier non limitatif de l'invention.

Il sera fait référence aux dessins annexés, parmi lesquels :

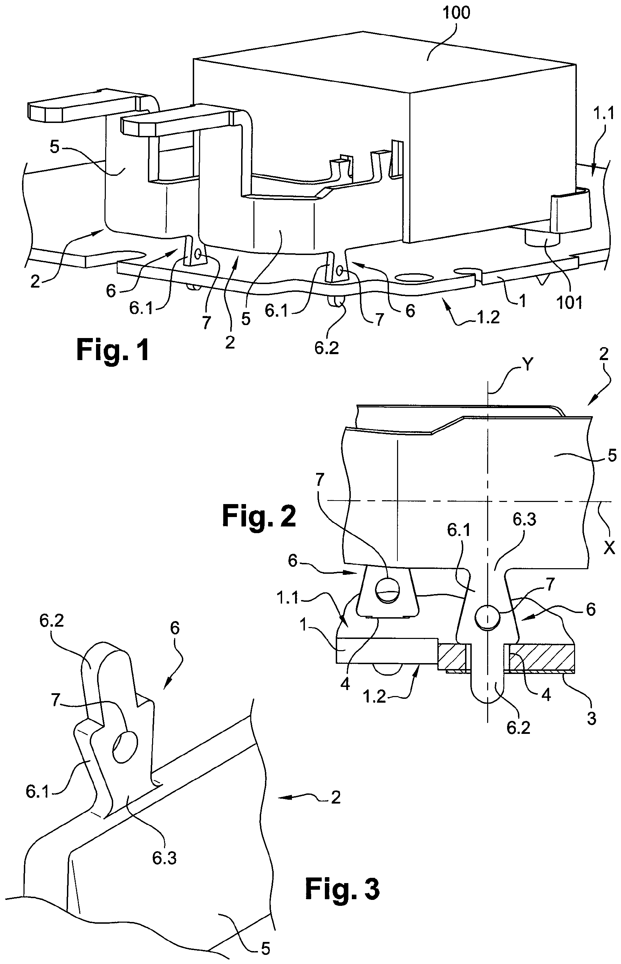

- la figure 1 est une vue partielle en perspective d'un ensemble selon l'invention,
- la figure 2 est une vue partielle en élévation de cet ensemble,
- la figure 3 est une vue partielle en perspective d'une partie inférieure d'un élément de cet ensemble.

L'invention concerne un ensemble soudé comprenant un élément en matériau thermiquement conducteur et un support.

En référence aux figures, l'invention est ici décrite en application à un équipement électrique, tel qu'un compteur, comportant une plaque 1 à circuit imprimé sur laquelle sont notamment fixés un relais de coupure 100 et des conducteurs de puissance 2 reliant les bornes du relais à des entrées du compteur. La plaque 1 forme un support et les conducteurs de puissance 2 forment des éléments fixés sur le support.

La plaque 1 à circuit imprimé a des faces 1.1, 1.2 opposées l'une à l'autre. Sur la face 1.2 s'étend le circuit imprimé qui comprend une piste conductrice 3. La plaque 1 est percée de trous 4 permettant la fixation des conducteurs de puissance 2.

Chaque conducteur de puissance 2, ici en cuivre qui est un matériau thermiquement conducteur, comporte une partie massive en saillie de laquelle s'étendent des pattes de fixation dont une seule est représentée ici. La partie massive est agencée sous la forme d'un barreau 5, d'axe longitudinal X, en saillie latérale duquel s'étendent les pattes de fixation 6. Les pattes de fixation 6 s'étendent selon des axes Y perpendiculaires à l'axe X.

Chaque patte de fixation 6 comprend :
- un tronçon intermédiaire 6.1 formant entretoise,
- un tronçon d'extrémité libre 6.2 saillant axialement du tronçon intermédiaire 6.1 pour s'étendre dans un des trous 4 et être soudé ou brasé à la piste conductrice 3 s'étendant sur la face 1.2.

Le tronçon intermédiaire 6.1 a une portion épaulée pour prendre appui sur la face 1.1 de la plaque 1, de part et d'autre du trou 4 dans lequel passe le tronçon d'extrémité libre 6.2. La portion épaulée du tronçon intermédiaire 6.1 jouxte le tronçon d'extrémité libre 6.2 et a une largeur supérieure au diamètre du trou 4.

Le tronçon intermédiaire 6.1 a une forme extérieure définissant une restriction de section 6.3 au moins selon la direction longitudinale X du barreau 5 formant la partie massive du conducteur de puissance 2. Le tronçon intermédiaire 6.1 a ici plus particulièrement une forme trapézoïdale dont la grande base est en appui contre la face 1.1 et la petite base est en contact avec le barreau. On comprend que la petite base constitue la restriction de section 6.3 puisque c'est à cet endroit que la forme extérieure du tronçon intermédiaire 6.1 définit la section transversale la plus faible.

Le tronçon intermédiaire 6.1 a des dimensions transversales maximales inférieures aux dimensions du barreau 5 dans des directions parallèles auxdites dimensions transversales maximales. En particulier, le tronçon intermédiaire 6.1 a une épaisseur inférieure à une épaisseur du barreau 5.

On notera que le tronçon intermédiaire 6.1 est percé d'une ouverture transversale 7, ici de forme circulaire, qui forme elle-aussi une restriction de section. L'ouverture transversale 7 est ménagée au voisinage de la portion épaulée, c'est-à-dire dans la partie la plus large du tronçon intermédiaire 6.1.

On notera également que les conducteurs de puissance 2 sont dimensionnés pour être rigides et sont fixés rigidement au relais de sorte que le relais 100 est maintenu écarté de la face 1.1 de la plaque 1 à la fois par les portions intermédiaires 6.1 des pattes de fixation 6 et par des plots 101 formant entretoises et moyens de fixation du relais 100 sur la plaque 1.

Bien entendu, l'invention n'est pas limitée aux modes de réalisation décrits mais englobe toute variante entrant dans le champ de l'invention telle que définie par les revendications.

En particulier, le tronçon intermédiaire peut avoir une autre forme et par exemple une forme en cornet.

Bien que la restriction de section ait été représentée jouxtant le barreau 5, la restriction de section peut s'étendre à n'importe quel endroit entre la portion épaulée et la zone de liaison du tronçon intermédiaire 6.1 au barreau. La patte de fixation peut ainsi avoir par exemple une forme extérieure en croix de Saint-Pierre.

En outre, l'invention n'est pas limitée à l'application décrite mais couvre plus généralement tout ensemble soudé selon la revendication 1. L'élément peut ainsi être également un élément de montage de composant dans un circuit électronique, un blindage ou autre. Le support peut être un conducteur, un boîtier ou autre.

Le tronçon intermédiaire peut être dépourvu d'ouverture 7 ou l'ouverture 7 peut avoir une forme autre que circulaire.

## Revendications

1. Ensemble soudé comprenant un élément (2) en matériau thermiquement conducteur et un support (1), l'élément (2) comportant un barreau (5) en saillie latérale duquel s'étend au moins une patte de fixation (6), comportant :
- un tronçon intermédiaire (6.1) formant entretoise, le tronçon intermédiaire étant épaulé pour prendre appui sur une première face (1.1) du support (1), de part et d'autre d'un trou (4) ménagé dans le support (1), le tronçon intermédiaire (6.1) ayant une forme extérieure définissant une restriction de section au moins selon une direction longitudinale du barreau ;
- un tronçon d'extrémité libre (6.2) saillant axialement du tronçon intermédiaire (6.1) pour s'étendre dans le trou (4) et être soudé à une deuxième face (1.2) du support (1) opposée à la première face (1.1) ;
**caractérisé en ce que** le tronçon intermédiaire (6.1) a une épaisseur inférieure à une épaisseur du barreau.

2. Ensemble soudé selon la revendication 1, dans lequel le tronçon intermédiaire (6.1) a une forme trapézoïdale.

3. Ensemble selon la revendication 1, dans lequel le tronçon intermédiaire (6.1) est percé d'une ouverture transversale (7).

4. Ensemble selon l'une quelconque des revendications précédentes, dans lequel le support (1) est une carte à circuit imprimé sur la deuxième face (1.2) duquel s'étend au moins une piste conductrice (3).

5. Ensemble selon la revendication 4, dans lequel l'élément (2) est un conducteur de puissance.

## Patentansprüche

1. Verschweißte Anordnung, umfassend ein Element (2) aus einem wärmeleitenden Material und einen Träger (1), wobei das Element (2) einen seitlich vorstehenden Stab (5) umfasst, von dem sich mindestens eine Befestigungslasche (6) erstreckt, umfassend:
- einen Zwischenabschnitt (6.1), der einen Abstandshalter bildet, wobei der Zwischenabschnitt eine Schulter hat, um auf einer ersten Fläche (1.1) des Trägers (1) zur Anlage zu kommen, zu beiden Seiten eines Lochs (4), das in dem Träger (1) ausgebildet ist, wobei der Zwischenabschnitt (6.1) eine äußere Form hat, die eine Querschnittsverengung mindestens in einer Längsrichtung des Stabes definiert;
- einen freien Endabschnitt (6.2), der axial vom Zwischenabschnitt (6.1) vorsteht, um sich in das Loch (4) zu erstrecken und mit einer zweiten Fläche (1.2) des Trägers (1), die der ersten Fläche (1.1) abgewandt ist, verschweißt zu werden;
**dadurch gekennzeichnet, dass** der Zwischenabschnitt (6.1) eine Dicke hat, die kleiner als eine Dicke des Stabes ist.

2. Verschweißte Anordnung nach Anspruch 1, bei der der Zwischenabschnitt (6.1) eine trapezförmige Form hat.

3. Anordnung nach Anspruch 1, bei der der Zwischenabschnitt (6.1) von einer Queröffnung (7) durchsetzt ist.

4. Anordnung nach einem der vorhergehenden Ansprüche, bei der der Träger (1) eine Karte mit gedruckter Schaltung auf der zweiten Fläche (1.2) ist, von der sich mindestens eine Leiterbahn (3) erstreckt.

5. Anordnung nach Anspruch 4, bei der das Element (2) ein Leistungsleiter ist.

## Claims

1. Welded assembly comprising an element (2) made of a thermally conducting material and a support (1), the element (2) comprising a bar (5) from which extends at least one laterally projecting fixing lug (6) comprising:
- an intermediate section (6.1) forming a spacer, the intermediate section being shouldered so as to bear on a first face (1.1) of the support (1), on either side of a hole (4) made in the support (1), the intermediate section (6.1) having an external shape defining a cross-sectional restriction at least along a longitudinal direction of the bar;
- a free end section (6.2) axially projecting from the intermediate section (6.1) to extend into the hole (4) and be welded to a second face (1.2) of the support (1) opposite the first face (1.1);
**characterised in that** the intermediate section (6.1) has a thickness that is less than the thickness of the bar.

2. Welded assembly according to claim 1, wherein the intermediate section (6.1) has a trapezoidal shape.

3. Welded assembly according to claim 1, wherein the intermediate section (6.1) is pierced with a transverse opening (7).

4. Welded assembly according to any one of the preceding claims, wherein the support (1) is a printed circuit board on the second face (1.2) of which extends at least one conductive track (3).

5. Welded assembly according to claim 4, wherein the element (2) is a power conductor.
